# EUROPÄISCHE PATENTANMELDUNG

(11) **EP 4 561 308 A1**
(43) Veröffentlichungstag der Anmeldung: **28.05.2025**
(21) Anmeldenummer: 24214589.4
(22) Anmeldetag: 21.11.2024
(51) Int. Cl.: H10K 30/50, H10K 30/88

(54) **DÜNNSCHICHT-SOLARZELLE, INSBESONDERE PEROWSKIT-SOLARZELLE, SOLARMODUL MIT SOLCHEN DÜNNSCHICHT-SOLARZELLEN UND VERFAHREN ZU DEREN HERSTELLUNG**

(30) Priorität: 21.11.2023 DE 102023132489; 21.11.2023 DE 102023132491; 21.11.2023 DE 102023132492
(71) Anmelder: Dammers, Dirk, 47441 Moers (DE); Taubert, Wilhelm, 46569 Hünxe (DE)
(72) Erfinder: Dammers, Dirk, 47441 Moers (DE); Taubert, Wilhelm, 46569 Hünxe (DE)
(74) Vertreter: Kreutzer, Ulrich

(57) **Zusammenfassung**

Es wird eine Dünnschicht-Solarzelle vorgestellt, die einen Schichtstapel und eine den Schichtstapel zu wenigstens einer Seite hin abdeckende Schutzschicht umfasst, wobei der Schichtstapel zumindest umfasst: ein Substrat, eine auf dem Substrat oder vom dem Substrat gebildete erste Elektrodenschicht, eine auf der ersten Elektrodenschicht gebildete erste photoaktive Schicht mit einem ersten Absorptionsspektrum und eine auf der ersten photoaktiven Schicht gebildete zweite Elektrodenschicht. Die Schutzschicht ist für elektromagnetische Strahlung zumindest des ersten Absorptionsspektrums zumindest partiell transparent, besteht aus einem elektronenstrahlgehärteten lösemittelfreien Acryllack ist und ist auf wenigstens einer von ihrer dem Schichtstapel zugewandten Seite und ihrer dem Schichtstapel abgewandten Seite mit einer funktionalen Struktur versehen.

## Beschreibung

### TECHNISCHES GEBIET DER ERFINDUNG

Die Erfindung betrifft eine vorzugsweise flexible Dünnschicht-Solarzelle, insbesondere eine Perowskit-Solarzelle, ein Solarmodul, insbesondere ein flexibles Solarmodul, mit solchen Dünnschicht-Solarzellen und ein Verfahren zur deren Herstellung.

### HINTERGRUND DER ERFINDUNG

Unter dem Begriff "Solarzelle" wird hier ein elektrisches Bauelement verstanden, das Energie von elektromagnetischer Strahlung, in der Regel von Sonnenlicht, unter Ausnutzung des photovoltaischen Effekts in elektrische Energie umwandelt. Solche Solarzellen sind typischerweise flach, d.h. ihre Dicke (auch Höhe genannt) ist deutlich geringer als ihre Breite und Länge (auch Tiefe genannt).

Unter dem Begriff "Solarmodul" wird hier ein aus mehreren miteinander verschalteten und flächig neben- oder übereinander angeordneten Solarzellen aufgebautes Modul verstanden. Solarmodule umfassen typischerweise weitere Bauelemente, insbesondere elektrische Anschlüsse, und können als montagefertige Module bereitgestellt werden.

Traditionelle Solarzellen auf Siliziumbasis (nachfolgend Dickschicht-Solarzellen) bzw. daraus gebildete Solarmodule werden typischerweise in einem Gestell- oder Rahmen hinter einer lichtdurchlässigen Scheibe oder Folie angeordnet und bilden starre und verhältnismäßig schwere Module, die meist auf Dächern von Gebäuden montiert, teilweise aber auch, insbesondere in sonnenreichen Regionen mit großen freien Flächen, bodennah auf Trägern in sogenannten "Solarparks" aufgestellt werden.

In jüngerer Zeit sind verstärkt leichte und teilweise auch flexible Solarzellen, nachfolgend Dünnschicht-Solarzellen genannt, und daraus aufgebaute Solarmodule entwickelt worden, wobei insbesondere druckbare Halbleiter die kostengünstige Herstellung von Solarzellen auf flexiblen Substraten ermöglichen. Halbleiter mit unterschiedlichen Absorptionsbanden ermöglichen auch die Herstellung sog. Mehrfachsolarzellen, die ein breites Strahlungsspektrum ausschöpfen und damit höhere Wirkungsgrade als die klassische Technologie sog. kristalliner Silizium-Einfachsolarzellen erzielen. Bei den druckbaren Halbleitern handelt es sich meist um organische Halbleiter (z.B. Polymere und kleine Moleküle) sowie um bestimmte anorganische Halbleiter wie die sog. Perowskite. Aus einer Vielzahl von Druckschriften sind aber auch Dünnschicht-Solarzellen auf Basis amorphen, nichtkristallinen Siliziums und anderer Halbleitermaterialien wie z.B. Kupfer-Indium-Gallium-Diselenid und Cadmiumtellurid und Kohlenwasserstoffverbindungen bekannt.

Dünnschicht-Solarzellen sind nicht nur typischerweise um einen Faktor von etwa 100 dünner als vergleichbare klassische Dickschicht-Solarzellen und mithin auch wesentlich leichter, sie benötigen auch weder Gestell noch Rahmen und sind je nach Trägermaterial sogar flexibel, was eine harmonische Anpassung an unterschiedlichste Konturen, z.B. architektonische Konturen, Konturen von Fahrzeugdächern, Aufbauten von Schiffen etc., erlaubt. Einige Dünnschicht-Solarzellen sind transparent und lassen sich damit quasi unsichtbar in Glasflächen integrieren. Sie können in relativ einfacher Weise deutlich großflächiger als Dickschicht-Solarzellen hergestellt werden, so dass zur Abdeckung einer bestimmten Fläche nicht mehrere Solarzellen zu einem Solarmodul miteinander verschaltet werden müssen, was den Verdrahtungsaufwand und damit die Kosten vorteilhaft weiter reduziert. Flexible Dünnschicht-Solarzellen sind z.B. aus der WO 2012 123109 A2 und der WO 2013 124 438 A2 bekannt, wobei letztere eine umfassende Zusammenstellung weiteren relevanten Standes der Technik enthält. Techniken zur Herstellung flexibler Dünnschicht-Solarzelle können daher als dem Fachmann bekannt angesehen werden, so dass auf deren einzelne Schritte hier nicht weiter eingegangen werden muss.

Jüngere Forschungen deuten darauf hin, dass sich unter den Dünnschicht-Solarzellen vor allem diejenigen auf Basis von Kohlenwasserstoffverbindungen, auch als "organische Solarzellen" bezeichnet, und diejenigen auf Basis sog. Perowskite, nachfolgend als Perowskit-Solarzellen bezeichnet, durchsetzen werden.

Organische Solarzellen bestehen typischerweise aus einer Folge dünner Schichten aus organischen Materialien, welche auf ein Trägermaterial z.B. aufgedampft oder aus einer Lösung aufgeschleudert werden. Das jeweils besonders geeignete Herstellungsverfahren richtet sich auch danach, ob in der Solarzelle niedermolekulare Verbindungen (sog. "Small Molecule Solar Cells" - SMSCs) oder makromolekulare Materialien verwendet werden sollen. Während bei SMSCs in der Regel durch Hochvakuum-Sublimation dünne Schichten auf den jeweiligen Träger aufgebracht werden, werden makromolekulare Materialien als Lösung auf dem Substrat abgeschieden. Dabei kommt häufig ein Spin-Coating-Verfahren zum Einsatz, bei dem die Lösung auf ein rotierendes Substrat getropft wird. Es sind aber auch verschiedene Verfahren bekannt, die sowohl strukturierte als auch großflächige Materialabscheidungen ermöglichen. Die elektrische Kontaktierung kann durch Metallschichten, transparente leitfähige Oxide (TCOs) und/oder transparente leitfähige Polymere (PEDOT-PSS, PANI) erfolgen.

Bei organischen Solarzellen kann auf den Einsatz solcher Stoffe verzichtet werden, die gemäß EU-Richtlinie 2002/95/EG (RoHS) als gefährlich gelten, so dass organische Solarzellen besonders umweltfreundlich sind. Sie lassen sich durch Wahl entsprechender Materialien leicht für breite Lichtspektren auslegen und verfügen in der Regel über ein gutes Schwachlichtverhalten.

Zur Herstellung organischer Solarzellen können schnelle und effiziente sog. Rolle-zu-Rolle-Verfahren genutzt werden, bei denen am Anfang einer Prozessstraße ein zu einer Rolle aufgewickeltes Material, typischerweise ein Trägermaterial, abgerollt, in der Prozessstraße entsprechend bearbeitet und beschichtet und am Ende der Prozessstraße wieder zu einer Rolle aufgewickelt wird.

Aus der WO 2009/007340 A1 ist die Verwendung von organischen Donor-Akzeptor-Mischungen und Fulleren-Derivaten zur Herstellung von photoaktiven Schichten zur Umwandlung von Lichtenergie in elektrische Energie mit einem für technische Anwendungen wie insbesondere organische Solarzellen und organische Photodetektoren ausreichenden Wirkungsgrad bekannt. Weitere Materialien für organische Solarzellen zeigt die EP 3 014 674 A1.

Die WO 2006/111511 A1 beschreibt Pentaarylentetracarbon- und Hexaarylensäureediimide als Aktivkomponenten in der Photovoltaik.

Aus der WO2007/116001 A1 sind Rylentetracarbonsäurederivate und deren Verwendung als organische Halbleiter vom n-Typ zur Herstellung von organischen Feldeffekttransistoren und von Solarzellen bekannt.

Die WO 2008/145172 betrifft substituierte Carboxyphthalocyanine und deren Verwendung als Aktivkomponente in der Photovoltaik.

Die EP 2 693 504 A1 offenbart den Aufbau von Dünnfilm-Solarzellen und untersucht den Zusammenhang von Löchertransportschichten in Abhängigkeit von Naphthalocyanine-Komplexen als Absorber.

Die EP 3 044 818 A1 lehrt eine Vorrichtung der organischen Elektronik z.B. in Form einer organischen Solarzelle, organischen Elektrolumineszenzvorrichtung, eines organischen Photodetektors oder eines organischen Feldeffekttransistors.

Aus den Druckschriften EP 3 021 056 A1 und EP 3 703 251 A1 sind jeweils in ein Gebäude integrierbare Photovoltaik-Baueinheiten bekannt, bei denen ein Photovoltaikverbundlagensystem mindestens ein Dünnschicht-Photovoltaikelement, insbesondere ein organisches Photovoltaikelement oder ein anorganisches Photovoltaikelement z.B. auf Basis eines Perowskits umfasst.

In der Photovoltaik werden unter Perowskiten Materialien mit einer bestimmten Kristallstruktur, der sog. Perowskit-Struktur, verstanden, ohne dass die Materialien dabei auf das dem nach dem Mineralogen Lew Perowski benannten Mineral mit der Summenformel CaTiO₃ beschränkt wären. Es hat sich gezeigt, dass eine Vielzahl von Materialien eine Perowskit-Struktur ausbilden, wobei die Materialien nach derzeitigem Kenntnisstand jeweils aus drei Ionenarten nach dem Muster ABX₃ aufgebaut sind, wobei A und B für zwei verschiedenartige Kationen und X für ein Anion steht. Wenn in dieser Beschreibung und den angehängten Ansprüchen von einem "Perowskit" gesprochen wird, sollen damit alle Materialen umfasst sein, die eine Perowskit-Struktur ausbilden.

Aus der DE 10 2018 216 485 A1 und der WO 2020 064 344 A1 sind Solarzellen auf Perowskit-Basis (kurz Perowskit-Solarzellen genannt) mit schaltungstechnisch verbesserter Gesamteffizienz bekannt.

Perowskit-Solarzellen können allein (d.h. ohne Solarzellen anderer Art) oder aber in einem sog. "Tandem-Modul" z.B. in Kombination mit einer herkömmlichen Silizium-Solarzelle betrieben werden, wie z.B. in der WO 2018 162496 A1 beschrieben.

Eine besondere Herausforderung bei allen Solarzellen, insbesondere aber bei Dünnschicht-Solarzellen und vor allem flexiblen Dünnschicht-Solarzellen ist deren witterungsbeständige, gleichzeitig aber lichtdurchlässige Verkapselung. Die zur Nutzung des photovoltaischen Effekts jeweils genutzten Materialen, nachfolgend kurz photoaktive Materialien genannt, müssen einerseits vor allem vor Feuchtigkeit, aber natürlich auch anderen Umwelteinflüssen wie Abrieb durch Sand und Staub bei Wind geschützt werden, andererseits soll aber möglichst viel der jeweils zu nutzenden elektromagnetischen Strahlung, typischerweise also sichtbares Licht und insbesondere Sonnenlicht, auf die Materialien gelangen können, wozu schon unzählige Lösungen vorgeschlagen wurden. Gleichwohl werden bei der überwiegenden Mehrheit der derzeit verwenden Solarzellen und Solarmodule Glasscheiben als lichtdurchlässiger Schutz verwendet, und zwar selbst dann, wenn die photoaktiven Materialien bereits eingekapselt sind. So lehrt die WO 1999 017379 A1 das Einkapseln einer Solarzelle in einer Polymerschicht, die elektronenstrahlgehärtet wird, wobei die eingekapselte Solarzelle dann aber unter einer Glasscheibe angeordnet werden soll. Das Elektronenstrahlhärten soll die thermische Kriechbeständigkeit ("thermal creep resistance") erhöhen, wobei darunter die dauerhafte Verformung von Polymeren aufgrund thermischer Einflüsse verstanden wird. In ähnlicher Weise wird auch in der WO 2013 122 199 A1 das Einkapseln einer organischen Solarzelle in einer elektronenstrahlgehärten Polymerschicht beschrieben, wobei auch hier die eingekapselte Solarzelle ebenfalls unter einer Glasscheibe angeordnet werden soll. Die elektronenstrahlgehärtete Polymerschicht dient als Permeationsbarriere und soll verhindern, das Wasser, Luft und insbesondere Sauerstoff an das photoaktive organische Material gelangt.

Das Elektronenstrahlhärten, also das durch Elektronenstrahlen initiierte oder begünstigte Vernetzen von Kunststoffen, ist seit langem bekannt und wird in der Industrie aufgrund diverser Vorteile umfassend genutzt. Die Härtung (Polymerisation und Vernetzung) erfolgt dabei durch niederenergetische Elektronen, die ihre Energie an Atome und Moleküle in dem auszuhärtenden Material übertragen. Die Vernetzung erfolgt dann je nach Material radikalisch oder kationisch. Bei der radikalischen Vernetzung werden sehr schnell freie Radikale erzeugt, welche die Polymerisation/Vernetzung in Gang setzen und es z.B. ermöglichen, elektronenbehandelte Beschichtungen mit verbesserten Eigenschaften wie UV-Beständigkeit, Kratzbeständigkeit und Abriebfestigkeit, thermische Beständigkeit. Typische Anwendungen sind Härten von Druckfarben z.B. Flexodruck und Rollenoffsetdruck auf Verpackungen, Härten von Beschichtungen z.B. für Möbeldekore, Coil Coating, Härten von Beschichtungen auf Platten, Fassadenelementen, Türen für Außenanwendungen, Härten hochabriebfester Fußbodenbeläge z.B. Fertigparkett, u.v.m.

Auch auf dem hier in Frage stehenden technischen Gebiet wurden schon unzählige Anwendungen elektronenstrahlhärtbarer Materialien beschrieben. So beschreibt die von Frau Dipl.-Ing. Juliane Fichtner im Jahr 2021 an der Universität Bremen eingereichte Dissertation mit dem Titel "Planarisierungsschichten in Permeationsbarriereschichtsystemen auf Basis elektronenstrahlhärtbarer Lacke" die Anwendung elektronenstrahlhärtbarer Lacke zum Schutz organischer Elektronikbauteile wie beispielsweise organischer Leuchtdioden oder organischer Solarzellen vor Oxidations- und Hydrolysereaktionen. Dabei werden alternierend Planarisierungsschichten und keramischen Schichten auf Polymersubstraten abgeschieden, wobei den Planarisierungsschichten die Aufgabe zukommt, Defekte abzudecken, das Defektwachstum zu unterbrechen, den keramischen Dünnschichten einen planen Untergrund und somit optimierte Wachstumsbedingungen zu bieten und Schichtspannungen zu absorbieren.

In der EP 3 198 660 B1 wird das Aufbringen einer Schutzschicht auf eine Solarzelle beschrieben. Dazu wird die Schutzschicht auf ein organisches elektronisches Rolle-zu-Rolle Halbfabrikat aufgebracht. Das Halbfabrikat umfasst ein fortlaufendes Substrat mit mindestens einem optoelektronischen Bauelement, umfassend ein Substrat, eine auf dem Substrat angeordnete Elektrode, einen organischen Schichtstapel und eine Gegenelektrode auf der dem Substrat abgewandten Seite des Schichtstapels, mindestens eine photoaktive organische Schicht zwischen der Elektrode und der Gegenelektrode. Die Schutzschicht wird auf der dem Substrat abgewandten Seite des mindestens einen optoelektronischen Bauelements so aufgebracht, dass sie den organischen Schichtstapel komplett bedeckt.

Gemäß der Beschreibung der EP 3 198 660 B1 soll die Schutzschicht aus einer lösemittelfreien auf Silikon basierten Komposition besteht, welche im sichtbaren Spektralbereich weitestgehend transparent ist, u.a. mittels Bestrahlung verlinkt ist, elektrisch isolierend ist und in einem fortlaufenden Prozess abgeschieden, beispielsweise gedruckt wurde, auch im Vakuum.

Gemäß den Patentansprüchen der EP 3 198 660 B1 soll die Schutzschicht den Schichtstapel vor und während der Endfertigung des Halbfabrikats vor Umwelteinflüssen und durch die Handhabung bedingte Beschädigungen schützen, wobei das Verfahren zum Aufbringen der Schutzschicht ein kontinuierliches Rolle-zu-Rolle-Verfahren im Vakuum ist, welches folgende Schritte umfasst:
- Auftragen eines wasser- und lösemittelfreien, zumindest temporär in der Phase des Auftrags fluiden, vernetz- oder aushärtbaren, mit dem Schichtstapel in fluider und in fester Phase verbindbaren und mit den Bedingungen während des Rolle-zu-Rolle-Verfahrens kompatiblen Schutzschichtmaterials mittels eines Druckverfahrens, welches wenigstens eines der Verfahren Siebdruck, Flexoprint, Plotten, Tintenstrahldruck, Schlitzdüsendruck oder ein zum 3D-Druck geeignetes Verfahren umfasst,
- Vernetzung oder Aushärtung des Schutzschichtmaterials durch wenigstens eines der Verfahren: UV-Vernetzung, thermische Vernetzung, Abkühlung oder Trocknung, wobei das Schutzschichtmaterial im flüssigen Zustand wasser- und lösemittelfrei ist und einen Dampfdruck aufweist, der unter dem beim Herstellungsverfahren vorgesehenen Umgebungsdruck liegt, und wobei beim Druckverfahren Bereiche von Kontakten und/oder Busbars des Schichtstapels entweder direkt von Schutzschichtmaterial freigehalten werden oder die Vernetzung selektiv erfolgt, so dass die Bereiche von Kontakten und/oder Busbars unvernetzt bleiben und leicht abgewischt, abgespült oder sonst wie von dem flüssigen Schutzschichtmaterial befreit werden können, während die übrigen Bereiche bereits vernetzt und fest mit dem Untergrund verbunden sind.

In der JP 2007 273 737 A werden die Bereitstellung einer Rückseitenschutzfolie mit hoher Beständigkeit gegen Wetter und Feuchtigkeit und auch einer höheren Flexibilität im Design und ein Solarzellenmodul beschrieben. Die Rückseitenschutzfolie für Solarzellen wird durch aufeinanderfolgendes Laminieren einer Farbschicht und einer Harzschicht mit witterungsbeständigen Eigenschaften auf die Oberfläche einer aufgedampften Dünnfilmschicht einer laminierten Gasbarriereschicht gebildet, die durch Auflaminieren eines Aluminiumoxids, Siliziumoxids oder eines anorganischen Oxids, das aus einer Mischung dieser Stoffe besteht, auf mindestens eine einzelne Oberfläche einer Grundmaterialschicht gebildet wird. In dieser Rückseitenschutzfolie für Solarzellen werden die Farbschicht und die Harzschicht mit Wetterbeständigkeitseigenschaften gebildet, indem nacheinander auf die Oberfläche der aufgedampften Dünnfilmschicht eine nicht härtende Deckschicht, die aus einer Acrylsystemtinte vom elektronenstrahlhärtenden Typ gebildet wird, und eine nicht härtende Harzschicht, die aus einem Beschichtungsmittel, das hauptsächlich aus einem Oligomer auf Acrylbasis besteht, auf die Oberfläche der aufgedampften Dünnschicht aufgebracht und diese Schichten dann gleichzeitig durch Bestrahlung mit Elektronenstrahlen gehärtet werden.

In der WO 2013 114 095 A1 wird eine strahlenhärtbare Harzzusammensetzung beschrieben, die sich zur Herstellung von Solarlaminaten in einfach ausführbaren, kontinuierlichen Verfahren eignen soll, wobei die Harzzusammensetzung zu einer guten Haftung in allen Bereichen zwischen den einzelnen Schichten der Solarlaminate führt. Die Harzzusammensetzung soll wenigstens eine isocyanatfunktionelle Verbindung umfassen, die wenigstens eine strahlenhärtende Gruppe ausgewählt aus der Gruppe bestehend aus Vinyl-, Propenyl-, Allyl-, Vinylether-, Maleinyl-, Fumaryl-, Maleinimid-, Dicyclopentadienyl-, Acrylamid- und (Meth)Acrylat-Gruppen aufweist (Komponente A) und wenigstens ein Polyol (Komponente B) zur Herstellung von Solarlaminaten. Strahlenhärtende Gruppen sollen funktionelle Gruppen sein, die unter Einwirkung aktinischer Strahlung durch Polymerisation reagieren. Unter aktinischer Strahlung werden elektromagnetische ionisierende Strahlung, insbesondere Elektronenstrahlen, UV-Strahlen sowie sichtbares Licht verstanden.

Die genannte WO 2013 114 095 A1 lehrt auch ein Verfahren zur Herstellung eines Solarlaminats umfassend wenigstens eine Solarzelle mit einer Vorderseite, einer Rückseite und dort angeschlossenen Rückseitenkontakten, eine Rückseitenfolie und eine Glasscheibe. Die strahlenhärtbare Harzzusammensetzung soll auf die Rückseitenfolie und die Glasscheibe aufgebracht und dort mittels aktinischer Strahlung ausgehärtet werden.

In der KR 10 2018 087470 A wird eine elektronenstrahlhärtbare Barriereverkapselung z.B. für organische Solarzellen beschrieben, die druckempfindliche Klebeeigenschaften hat und die nach dem Verkleben mit der Solarzelle eine dauerhafte Verkapselung ermöglicht und die organischen Wirkstoffe vor Umwelteinflüssen wie Luftfeuchtigkeit und Sauerstoffeinwirkung schützt.

Aus der EP 2 525 414 A2 ist ein Verfahren zur Herstellung eines glaslosen Photovoltaik-Moduls mit einer elektrischen Reihenschaltung mehrerer photovoltaischer Solarzellen, die verkapselt zwischen einer Kunststoffschicht aus einem transparenten, thermoplastischen Kunststoff und einem rückseitigen Trägersubstrat angeordnet sind, bekannt. Dabei wird die Kunststoffschicht durch Extrusion des thermoplastischen Kunststoffs auf einen Rohling des Photovoltaik-Moduls aufgetragen. Handelt es sich bei dem Rohling um einen Photovoltaik-Rohling in Dünnschichttechnik, soll dieser vor dem Verkapseln mit einer Sperrschicht versehen werden. Die Kunststoffschicht soll das photoaktive Material gegen Verschmutzung und Verkratzen schützen und über die ggf. vorhandene Sperrschicht hinaus eine zusätzliche Sperrwirkung gegen Eindringen von Feuchtigkeit haben.

Aus der JP H06 334207 A ist eine Solarzelle bekannt, bei der die lichtempfindliche Schicht mit einer oder mehreren transparenten organischen Polymerschichten versiegelt ist. Mindestens eine dieser Schichten wird durch Elektronenstrahlbestrahlung vernetzt. Dieses Verfahren zielt darauf ab, die thermische Verformung des Beschichtungsmaterials zu verhindern und die Produktivität durch verkürzte Vernetzungszeiten zu erhöhen.

Die US 2023/0340297 A1 beschreibt eine photohärtbare Zusammensetzung für die Versiegelung von Solarzellen, die eine photohärtbare Acrylharzkomponente und ein Tonmineralpulver enthält. Diese Zusammensetzung zielt darauf ab, eine verbesserte Feuchtigkeitsbarriere zu schaffen. Die Aushärtung erfolgt durch Bestrahlung mit Licht, typischerweise UV-Licht oder Elektronenstrahlen.

Aus der US 2014 0137939 A1 ist ein Solarzellenmodul und ein Verfahren zu dessen Herstellung bekannt, wobei das Modul ein Solarzellensubmodul umfasst, das durch einen Klebstoff versiegelt ist. Auf der Vorderseite des Solarzellensubmoduls sind eine Wasserdampfsperrfolie, eine erste Klebstoffschicht und eine Vorderseitenschutzschicht laminiert. Auf der Rückseite sind eine zweite Klebstoffschicht und eine Rückseitenschutzschicht angeordnet. Die Druckschrift zielt darauf ab, ein Solarzellenmodul bereitzustellen, das eine hohe mechanische Festigkeit und Schlagfestigkeit aufweist und gleichzeitig leicht und kostengünstig ist. Dazu wird vorgeschlagen, für die Vorderseitenschutzschicht eine Kunststoffplatte zu verwenden, die eine thermische Schrumpfung von nicht mehr als 0,04% aufweist.

### OFFENBARUNG DER ERFINDUNG

Wenngleich schon viele Ansätze zur Verkapselung von Solarzellen und insbesondere Dünnschicht-Solarzellen vorgestellt wurden, besteht in verschiedener Hinsicht Bedarf an einer verbesserten Verkapselung. Eine besondere Herausforderung stellt dabei dabei der an sich vielversprechende Einsatz von Perowskiten dar, die eine unkomplizierte Beschichtung von geeigneten Substraten erlauben. Perowskite können in flüssiger Form auf Oberflächen gestrichen, gedruckt oder aufgesprüht werden, so dass sich damit kostengünstig Dünnschicht-Solarzellen herstellen lassen, die teilweise sehr gute Wirkungsgrade besitzen. Unverkapselte Perowskite besitzen jedoch eine schlechte Stabilität. Als ionisches Kristallmaterial ist Perowskit zerbrechlich, anfällig für Hydrolyse und Oxidation und hat eine geringe Temperaturbeständigkeit.

Um bei Dünnschicht-Solarzellen den Wirkungsgrad zu erhöhen, wird in der bereits genannten EP 2 525 414 A2 vorgeschlagen, in den zur Verkapselung verwendeten thermoplastischen Kunststoff unmittelbar nach seinem Aufbringen auf einen die aktiven Komponenten einer Dünnschicht-Solarzelle bildenden Schichtstapel mittels Walzen eine prismatische Struktur einzupressen, die zu einer Steigerung der Leistung der Solarzelle bei senkrechtem Lichteinfall von ca. 3 % und bei schrägem Lichteinfall von bis zu 20 % führen soll.

Allerdings ist das Verwenden eines thermoplastischen Kunststoffs als Schutzschicht zur Verkapselung von Dünnschicht-Solarzellen und insbesondere Perowskit-Solarzellen aus mehreren Gründen nachteilig. Gerade Perowskit-Solarzellen leiden bei der mit einer solchen Verkapselung einhergehenden Erwärmung, und generell benötigt thermoplastischer Kunststoff relativ viel Zeit bis zu seiner vollständigen Aushärtung, während derer die Schutzwirkung der Schutzschicht nicht vollständig zur Verfügung steht.

Aufgrund von Bestimmungen des Denkmalschutzes, aber auch aus ästhetischen und anderen Gründen, verbietet sich manchmal das Anbringen von Solarzellen einschließlich Dünnschicht-Solarzellen. Abhilfe könnte eine ästhetisch ansprechende Gestaltung der Dünnschicht-Solarzellen z.B. durch Bedrucken selbiger schaffen, jedoch unterliegen solche Drucke auf den Solarzellen dann den u.U. harten Umweltbedingungen und sind in der Regel nicht kratzfest, nicht begehbar und schon gar nicht "wüstentauglich", können also hohen Abriebkräften, wie sie bei Sandstürmen auftreten, nicht widerstehen.

Schließlich stellt die Verschmutzung von Dünnschicht-Solarzellen und -modulen, insbesondere flexiblen Dünnschicht-Solarzelle und -modulen ein besonderes Problem dar, da solche Zellen und Module - was gerade ihr Vorteil ist - in völlig unterschiedlichen Einbausituation angebracht werden können, z.B. an gebogenen Fassaden und gewinkelten Dächern, was aber ihre Reinigung erheblich erschwert.

Davon ausgehend liegt der Erfindung die Aufgabe zugrunde, eine vorzugsweise flexible Dünnschicht-Solarzelle, insbesondere eine Perowskit-Solarzelle, ein Solarmodul, insbesondere ein flexibles Solarmodul, und ein Verfahren zur deren Herstellung anzugeben, die es ermöglichen, eine Dünnschicht-Solarzelle in kostengünstiger und effizienter Weise mit einer Schutzschicht zu versehen, die auf zumindest einer Seite eine funktionalen Struktur, die zumindest eines der vorgenannten technischen Probleme (Wirkungsgradverbesserung, visuelle Erscheinung, Verschmutzung) löst oder mindert, ohne die Dünnschicht-Solarzelle während des Aufbringens der Schutzschicht einer gerade für Materialien wie Perowskite schädlichen Wärmebelastung auszusetzen.

In einem Nebenaspekt liegt der Erfindung die Aufgabe zugrunde, eine Perowskit-Solarzelle, insbesondere eine flexible Solarzelle, ein Solarmodul, insbesondere ein flexibles Solarmodul, und ein Verfahren zur deren Herstellung anzugeben, die es ermöglichen, ein in an sich bekannter Weise auf ein geeignetes Trägersubstrat aufgebrachtes Perowskit mit einer Schutzschicht zu überziehen und so zu verkapseln, dass es vor Luft und Wasser geschützt ist, es aber während des Aufbringens der Schutzschicht keiner für das Perowskit schädlichen Wärmebelastung auszusetzen.

Die Aufgabe wird gelöst von einer Dünnschicht-Solarzelle mit den Merkmalen des Anspruchs 1, einem Solarmodul mit den Merkmalen des Anspruchs 10 und einem Verfahren mit den Merkmalen des Anspruchs 11 oder des Anspruch 12. Vorteilhafte Ausgestaltungen und Weiterbildungen sind Gegenstand der Unteransprüche.

Erfindungsgemäß umfasst eine Dünnschicht-Solarzelle einen Schichtstapel und eine den Schichtstapel zu wenigstens einer Seite hin abdeckende Schutzschicht, wobei der Schichtstapel zumindest umfasst: ein Substrat, eine auf dem Substrat oder vom dem Substrat gebildete erste Elektrodenschicht, eine auf der ersten Elektrodenschicht gebildete erste photoaktive Schicht mit einem ersten Absorptionsspektrum und eine auf der ersten photoaktiven Schicht gebildete zweite Elektrodenschicht. Die Schutzschicht ist für elektromagnetische Strahlung zumindest des ersten Absorptionsspektrums zumindest partiell transparent, aus einem elektronenstrahlgehärteten lösemittelfreien Acryllack gebildet und zumindest auf einer von ihrer dem Schichtstapel abgewandten oder dem Schichtstapel zugewandten Seite mit einer funktionalen Struktur versehen. Die Schutzschicht selbst kann erstaunlich dünn ausgestaltet werden und z.B. eine Dicke im Bereich von etwa 30 bis etwa 600 µm aufweisen. Bei vielen Anwendungen haben sich Schichtdicken im Bereich von etwa 200 bis 400 µm besonders bewährt.

Eine funktionale Struktur kann wenigstens eine sein von einer Bedruckung, einer lichtleitenden Struktur und einer einen Lotus-Effekt erzeugenden Struktur.

Handelt es ich bei der funktionalen Struktur um eine Bedruckung, so kann diese zwar den Wirkungsgrad der Solarzelle beeinträchtigen, es dafür aber erlauben, Solarzellen an Stellen anzubringen, an denen dies sonst z.B. aus ästhetischen Gründen nicht möglich wäre. Die Bedruckung kann einen bestimmten visuellen Effekt erzeugen und z.B. ein bestimmtes Muster enthalten. Zur Bedruckung können unterschiedliche an sich bekannte Verfahren eingesetzt werden, wie z.B. Siebdruck, Tintenstrahl-Druck etc.

Ist eine Bedruckung vorgesehen, befindet sich diese vorzugweise auf der dem Schichtstapel zugewandten Seite der Schutzschicht. Die Schutzschicht schützt dann auch die Bedruckung vor Umwelteinflüssen.

Alternativ oder zusätzlich kann die funktionale Struktur auch eine lichtleitende Struktur z.B. in Form von Prismen oder Linsenstrukturen wie Fresnel-Strukturen umfassen und vorteilhaft den Wirkungsgrad der Solarzelle erhöhen, indem mehr Strahlung "eingefangen" (also weniger Strahlung reflektiert) und zu der oder den photoaktiven Schichten geleitet wird. Eine lichtleitende Struktur kann Anti-Reflexionsstrukturen umfassen, was es erlaubt, entsprechende Solarzellen an Stellen anzubringen, an denen reflektierende Effekte unerwünscht sind, z.B. weil sie Verkehrsteilnehmer je nach Sonnenstand blenden könnten.

Alternativ oder zusätzlich kann die funktionale Struktur auch eine einen Lotus-Effekt erzeugende Struktur umfassen, worunter eine Struktur verstanden wird, die bewirkt, dass Verschmutzungen schlechter bis gar nicht an der Solarzelle anhaften und dass bei Regen Wasser leichter abrollt und dabei etwaige Schmutzpartikel mitnimmt, es also quasi zu einer Selbstreinigung kommt, wodurch die Effizienz der Zelle über längere Zeit bewahrt und die Leistung der Solarzelle verbessert wird.

Eine einen Lotus-Effekt erzeugende Struktur besteht dabei vorzugsweise aus einer Mikrostruktur, die winzige Erhebungen oder Noppen umfasst und auf der sich eine zusätzliche Nanostruktur befindet, die die Oberfläche der Schutzschicht noch feiner strukturiert. Damit wird die Oberfläche stark wasserabweisend (hydrophob), was noch durch eine zusätzliche chemische Beschichtung oder Behandlung verstärkt werden kann. Wassertropfen bilden dann auf einer solchen Oberfläche einen sehr hohen Kontaktwinkel (über 150°), wodurch sie nahezu kugelförmig werden und Schmutzpartikel kaum an der Oberfläche haften und bei Regen von abrollenden Wassertropfen mitgenommen werden.

Durch die Verwendung eines elektronenstrahlgehärteten lösemittelfreien Acryllacks als Schutzschicht ist es möglich, funktionale Strukturen wie lichtleitende oder einen Lotus-Effekt erzeugende Strukturen in besonders einfacher Weise, z.B. durch Prägen mittels einer Walze oder vorzugsweise mittels einer Releasefolie, in die Schutzschicht einzubringen.

Durch die Verwendung eines elektronenstrahlgehärteten lösemittelfreien Acryllacks als Schutzschicht kann zudem das bislang mit dem Aufbringen der Schutzschicht verbundene Erwärmen des Schichtstapels entfallen, was sich positiv auf die Haltbarkeit der Dünnschicht-Schicht auswirken kann.

Ein elektronenstrahlgehärteter lösemittelfreier Acryllack bringt zudem viele weitere Vorteile mit sich. Er ist flexibel, kratzfest, UV- und witterungsbeständig, begehbar und wüstentauglich, kann also hohen Abriebkräften, wie sie bei Sandstürmen auftreten, widerstehen. Aufgrund seiner Eigenschaften wird er auch als "Glas von der Rolle" bezeichnet, da er auch in Form eines als aufrollbaren Folienproduktes hergestellt werden kann. Zudem besteht die Möglichkeit, in ihn bestimmte weitere Materialien, wie Farbstoffe, oder Elemente einzubringen. Wird er flüssig auf den Schichtstapel aufgetragen, was mit unterschiedlichen Aufbringtechniken möglich ist, besteht die Möglichkeit, direkt beim Aufbringen bestimmte weitere Elemente wie Anschlüsse zu den Elektrodenschichten einzubringen bzw. diese Elemente die Schutzschicht durchdringen zu lassen.

Bei einer besonders bevorzugten Ausführungsform ist die erste photoaktive Schicht eine Perowskit-Schicht. Damit wird es möglich, kostengünstig eine Dünnschicht-Solarzelle mit hohem Wirkungsgrad herzustellen.

Bei einer bevorzugten Ausführungsform bildet die Schutzschicht zusammen mit dem Substrat eine vollständige Umhüllung der anderen Schichten des Schichtstapels, wobei Anschlüsse zu den Elektrodenschichten durch die Umhüllung geführt sind. Alternativ kann die Schutzschicht auch selbst eine vollständige Umhüllung der anderen Schichten des Schichtstapels bildet, wobei Anschlüsse zu den Elektrodenschichten durch die Umhüllung geführt sind. Die Umhüllung bildet in beiden Fällen eine Gas- und Flüssigkeitspermeationsbarriere und verhindert zuverlässig, das Wasser, Luft und insbesondere Sauerstoff an die erste photoaktive Schicht gelangt.

Da es wie schon erwähnt möglich ist, in den Acryllack bestimmte Stoffe oder Bauelemente einzubetten, kann auch das Substrat selbst aus einem elektronenstrahlgehärteten lösemittelfreien Acryllack bestehen, auf den dann die anderen Schichten des Schichtstapels in an sich bekannter Weise aufgebracht werden.

Bei einer bevorzugten Ausführungsform ist die Dünnschicht-Solarzelle flexibel, was viele verschiedene Vorteile mit sich bringt. So kann sie effizient und kostengünstig in sog. Rolle-zu-Rolle-Verfahren hergestellt werden. Entsprechend Rollen lassen sich leicht transportieren und weiter be- und verarbeiten. Flexible Solarzellen erlauben es insbesondere, die Solarzellen an unterschiedlichsten Stellen, insbesondere Außenwänden und gewölbten Dächern von Gebäuden, Land- und Wasserfahrzeugen anzubringen, ohne in das optische Gesamtbild einzugreifen, wie dies klassische starre Solarzellen tun.

Die Verwendung eines elektronenstrahlgehärteten Acryllacks erlaubt es zudem vorteilhaft, bestimmte farbgebende Stoffe beizumischen, was zwar unter Umständen den Wirkungsgrad der Solarzelle mindern kann, es aber ermöglicht, Solarzellen auch an Stellen anzubringen, wo klassische schwarze Solarzellen als störend empfunden würden oder sogar z.B. bei denkmalgeschützten Gebäuden verboten wären. Soll ein Lotus-Effekt erzeugt werden, können dem Lack vor der Härtung hydrophobe Additive beigemischt werden, die während der Härtung an die Oberfläche migrieren, d.h. es kann zunächst dafür gesorgt werden, dass eine gute Haftung zwischen dem die Schutzschicht bildenden Lack und der Solarzelle besteht, und dann können dem nicht vollständig ausgehärteten Lack Additive zugegeben werden.

Strukturen können auch durch gezieltes partielles Aushärten erzeugt werden, in dem die die Aushärtung bewirkenden Elektronenstrahlen auf bestimmte Bereiche des Lacks gelenkt werden.

Bei einer weiteren bevorzugten Ausführungsform bestehen die Schutzschicht und/oder das Substrat aus einem bei Elektronenbestrahlung radikalisch aushärtenden Acryllack, insbesondere einem polymerisierbare Kohlenstoffdoppelbindungen enthaltenden Acryllack. Solche Lacke lassen sich mittels Elektronbestrahlung besonders schnell, typischerweise in wenigen Sekunden aushärten, so dass entsprechend schnell auch der durch die damit gebildete Schutzschicht zur Verfügung gestellte Schutz des Schichtstapels und insbesondere der Perowskit-Schicht wirksam wird.

Der radikalisch aushärtende Acryllack enthält bevorzugt etwa 20 bis 70 Gew.-% Oligomere mit einem Molekulargewicht von etwa 500 g/mol und mehr, insbesondere Acrylate, Methacrylate, ungesättigte Polyester, Styrole, Poly-ENE-Thiolsysteme und Isopropene-Styren-Block-Copolymere, aromatische und aliphatische Epoxyacrylate, aromatische und aliphatische Urethanacrylate, Polyester- und Polyetheracrylate und acrylierte Acrylate und acrylierte Öle.

Der radikalisch aushärtende Acryllack enthält bevorzugt etwa 30 bis 80 Gew.-% Monomere mit einem Molekulargewicht von etwa 500 g/mol und weniger enthält, insbesondere Verbindungen mit einer oder mehreren funktionellen Gruppen wie insbesondere Acrylester, Methacrylester, Maleininate, Fumarate, cyclische Vinylamide, Vinylether, Styrol und Allylether.

Bei einer weiteren besonders bevorzugten Ausführungsform enthält der Schichtstapel wenigstens eine zweite photoaktive Schicht mit einem zweiten Absorptionsspektrum, das sich von dem ersten Absorptionsspektrum unterscheidet, wobei die Schutzschicht auch für elektromagnetische Strahlung des zweiten Absorptionsspektrums zumindest partiell transparent ist. Dies erlaubt es vorteilhaft, eine Solarzelle mit einem besonders hohen Wirkungsgrad zu schaffen, die elektromagnetische Strahlung verschiedener, sich ggf. teilweise überlappender Wellenlängenbereiche nutzen kann. Ansätze zu solchen auch als Tandem-Solarzellen" bezeichneten Solarzellen wurden bereits beschrieben, z.B. in der bereits erwähnten WO 2018 162496 A1.

Ein erfindungsgemäßes Dünnschicht-Solarmodul umfasst eine Mehrzahl von erfindungsgemäßen Dünnschicht-Solarzellen, die in monolithischer Serienschaltung, also mittels einer bereits während des Aufbringens der Schichten der Schichtstapel durch Strukturieren der einzelnen Schichten realisierte Verbindung, verschaltet sind, wodurch vorteilhaft ein aufwändiges anschließendes Verschalten entfällt.

Gemäß einem ersten erfindungsgemäßen Verfahren zum Herstellen einer Dünnschicht-Solarzelle werden zunächst ein Schichtstapel aus wenigstens einem Substrat, einer auf dem Substrat oder vom dem Substrat gebildeten ersten Elektrodenschicht, einer auf der ersten Elektrodenschicht gebildeten ersten photoaktiven Schicht mit einem ersten Absorptionsspektrum und einer auf der ersten photoaktiven Schicht gebildeten zweiten Elektrodenschicht bereitgestellt, dann eine den Schichtstapel zu wenigstens einer Seite hin abdeckende, für elektromagnetische Strahlung zumindest des ersten Absorptionsspektrums zumindest partiell transparente Schutzschicht aufgebracht, wobei die Schutzschicht eine Schicht aus einem lösemittelfreien Acryllack ist, worauf eine funktionale Struktur auf der dem Schichtstapel abgewandten Seite der Schutzschicht erzeugt und schließlich der Acryllack mittels Elektronbestrahlung ausgehärtet wird.

Bei einem zweiten erfindungsgemäßen Verfahren zum Herstellen einer Dünnschicht-Solarzelle werden zunächst ein Schichtstapel aus wenigstens einem Substrat, einer auf dem Substrat oder vom dem Substrat gebildeten ersten Elektrodenschicht, einer auf der ersten Elektrodenschicht gebildeten ersten photoaktiven Schicht mit einem ersten Absorptionsspektrum und einer auf der ersten photoaktiven Schicht gebildeten zweiten Elektrodenschicht bereitgestellt; gleichzeitig oder zeitversetzt dazu wird eine für elektromagnetische Strahlung zumindest des ersten Absorptionsspektrums zumindest partiell transparente Folie aus einem lösemittelfreien Acryllack durch Elektronenstrahlhärten hergestellt, und zwar so, dass die fertige Folie auf zumindest einer Seite eine funktionale Struktur aufweist. Dies kann durch Gießen des Lacks auf entsprechend geformte Strukturen auch "on the fly" erfolgen, kann aber auch durch Prägen des teilausgehärteten ("gelierten") Lacks z.B. mittels einer sog. Releasefolie erfolgen. Die Folie wird als Schutzschicht auf den Schichtstapel derart aufgebracht, dass die Folie den Schichtstapel zu wenigstens einer Seite hin abdeckt und sich die funktionale Struktur auf zumindest einer von der dem Schichtstapel abgewandten Seite und der dem Schichtstapel zugewandten Seite der Folie befindet. Je nach dem, um was für eine funktionale Struktur es sich handelt, kann diese bevorzugt auf der dem Schichtstapel zugewandten oder abgewandten Seite der Folie befinden. Handelt es sich bei der funktionalen Struktur um eine Bedruckung, wird die Folie typischerweise so angeordnet, dass sich die Bedruckung auf der dem Schichtstapel zugewandten Seite der Folie befindet. Handelt es sich bei der funktionalen Struktur um eine lichtleitende und/oder einen Lotus-Effekt erzeugende Struktur, wird die Folie typischerweise so angeordnet, dass sich die Struktur auf der dem Schichtstapel abgewandten Seite der Folie befindet. Je nach speziellem Anwendungsfall können auch andere Anordnungen sinnvoll sein und vorgesehen werden.

Das oben genannte erste Verfahren kann als Nass-Verfahren, das zweite als Trocken-Verfahren bezeichnet werden. In beiden Verfahren werden aber die oben genannten vorteilhaften Eigenschaften elektronenstrahlhärtbarer lösemittelfreier Acryllacke genutzt. Bei beiden Verfahren können funktionale Strukturen z.B. mittels einer Releasefolie in die Schutzschicht eingebracht werden. Die Releasefolie wird beim genannten Nass-Verfahren nach dem Aufbringen der Schutzschicht und vor deren Aushärtung auf die Schutzschicht gepresst, und beim genannten Trocken-Verfahren bei der Herstellung der Folien vor deren Aushärtung auf selbige gepresst. In beiden Fällen wird die Releasefolie nach dem jeweiligen Aushärten abgezogen, was auch erst erst kurz vor dem Einsatz der Solarzelle erfolgen kann, so dass die Releasefolie als zusätzlicher Schutz beim Transport und der weiteren Be- und Verarbeitung der Solarzelle dienen kann.

Generell kann das Erzeugen der funktionalen Struktur wenigstens einen der folgenden Schritte oder eine beliebige Kombination dieser Schritte umfassen:
- Bedrucken der Schutzschicht vor oder nach deren vollständigem Aushärten,
- Prägen einer lichtleitenden Struktur in die Schutzschicht vor deren vollständigem Aushärten,
- Erzeugen von zumindest Teilen der funktionalen Struktur durch selektive Steuerung eines Elektronenstrahls während des Elektronenstrahlhärten,
- Erzeugen einer Lotus-Effekt erzeugenden Oberfläche auf der Schutzschicht durch Prägen einer Mikrostruktur in die Schutzschicht vor deren vollständigem Aushärten und Aufbringen von Nanopartikeln auf die Mikrostruktur vor oder nach dem vollständigen Aushärten der Schutzschicht.

Die Erfindung erlaubt es besonders vorteilhaft, sowohl auf der dem Schichtstapel zugewandten als auch auf der dem Schichtstapel abgewandten Seite der Folie funktionale Strukturen zu erzeugen, so dass eine entsprechende Solarzelle z.B. eine Bedruckung, um bestimmte visuelle Effekte zu erzeugen, gleichzeitig aber auch bestimmte lichtleitende und/oder eine Selbstreinigung (Lotus-Effekt) begünstigende Strukturen aufweisen kann. Die lichtleitende Struktur selbst kann so gestaltet werden, dass sie gleichzeitig einen Lotus-Effekt zeigt. Allgemein kann die Schutzschicht nach der Härtung einer Nachbehandlung unterzogen werden, z.B. einer wasserabstoßenden Imprägnierung.

Die Folie und/oder der Schichtstapel kann/können mit einer Haftschicht z.B. in Form einer Selbstklebeschicht oder einem aufgebrachten Kleber versehen sein. Es kann auch vorgesehen sein, dass die Folie zunächst nur teilausgehärtet wird, so dass die dem zu schützenden Schichtstapel zugewandte Seite der Folie noch nicht vollständig vernetzt ist, die Folie dann z.B. in einem Rolle-zu-Rolle-Verfahren auf den Schichtstapel aufgebracht und dort dann mittels Elektronenbestrahlung fertig ausgehärt wird. Hier zeigt sich ein weiterer Vorteil der Elektronenstrahlhärtung, nämlich die Möglichkeit, gezielt bestimmte Bereiche in dem zu härtenden Material auszuhärten. Dies kann, wie bereits erwähnt, vorteilhaft auch dazu genutzt werden, bestimmte funktionale Strukturen zu erzeugen.

Bei einer bevorzugten Ausführungsform erfolgt das Aufbringen der Schutzschicht auf den Schichtstapel derart, dass sie zusammen mit dem Substrat eine vollständige Umhüllung der anderen Schichten des Schichtstapels bildet, wobei Anschlüsse zu den Elektrodenschichten durch die Umhüllung geführt sind. Alternativ kann das Aufbringen der Schutzschicht auf den Schichtstapel auch derart erfolgen, sie eine vollständige Umhüllung der anderen Schichten des Schichtstapels bildet, wobei Anschlüsse zu den Elektrodenschichten durch die Umhüllung geführt sind.

Bei einer weiteren bevorzugten Ausführungsform ist ein Schritt des Bildens des Substrats durch Elektronenstrahlhärten eines lösemittelfreien Acryllacks vorgesehen. Die vorteilhaften Eigenschaften von Acryllacken können also auch für das Substrat selbst genutzt werden. Bei dem Acryllack für das Substrat und dem Acryllack für die Schutzschicht kann es sich um unterschiedliche Lacke oder denselben Lack, ggf. mit unterschiedlichen Zuschlagsstoffen versehen, handeln.

Bei einer weiteren bevorzugten Ausführungsform wird ein bei Elektronenbestrahlung radikalisch aushärtender Acryllack, insbesondere ein polymerisierbare Kohlenstoffdoppelbindungen enthaltender Acryllack, zur Bildung der Schutzschicht und/oder des Substrats verwendet. Dies hat den Vorteil, dass die Aushärtung extrem schnell erfolgt, praktisch unmittelbar nach der Elektronenbestrahlung, während eine kationische Aushärtung deutlich mehr Zeit benötigt.

Bei einer weiteren bevorzugten Ausführungsform umfasst der verwendete Acryllack etwa 20 bis 70 Gew.-% Oligomere mit einem Molekulargewicht von etwa 500 g/mol und mehr, insbesondere Acrylate, Methacrylate, ungesättigte Polyester, Styrole, Poly-ENE-Thiolsysteme und Isopropene-Styren-Block-Copolymere, aromatische und aliphatische Epoxyacrylate, aromatische und aliphatische Urethanacrylate, Polyester- und Polyetheracrylate und acrylierte Acrylate und acrylierte Öle.

Bei einer weiteren bevorzugten Ausführungsform umfasst der verwendete Acryllack etwa 30 bis 80 Gew.-% Monomere mit einem Molekulargewicht von etwa 500 g/mol und weniger, insbesondere Verbindungen mit einer oder mehreren funktionellen Gruppen wie insbesondere Acrylester, Methacrylester, Maleininate, Fumarate, cyclische Vinylamide, Vinylether, Styrol und Allylether.

Bei einer weiteren bevorzugten Ausführungsform wird wenigstens eine zweite photoaktive Schicht mit einem zweiten Absorptionsspektrum, das sich von dem ersten Absorptionsspektrum unterscheidet, in dem Schichtstapel vor dem Aufbringen der Schutzschicht bereitgestellt, wobei die Schutzschicht auch für elektromagnetische Strahlung des zweiten Absorptionsspektrums zumindest partiell transparent ist. In der oben bereits beschriebenen Weise erlaubt dies die Herstellung einer einfallende Strahlung, insbesondere Sonnenlicht, besonders effektiv nutzenden Solarzelle. Eine solche Zelle kann so aufgebaut werden, dass auf dem Substrat eine übliche Siliziumzelle gebildet, darauf eine Zwischenschicht wie z.B. eine Zinndioxid-Schicht abgeschieden und auf diese dann eine Perowskit-Schicht aufgebracht und und mit einem Lochleitermaterial bedeckt wird. Bei dem Lochleitermaterial kann es sich um ein organisches Material wie insbesondere dotiertes Spiro-OMeTAD handelt. Auch hier zeigt sich ein Vorteil der Erfindung: das dotierte Spiro-OMeTAD zieht verstärkt Feuchtigkeit an, die aber durch die Schutzschicht, insbesondere eine unmittelbar nach dem Aufbringen des dotierten Spiro-OMeTAD auf den Schichtstapel aufgebrachte und durch Elektronenbestrahlung praktisch instantan ausgehärtete Schutzschicht effektiv abgeblockt werden kann. Anstelle von dotiertem Spiro-OMeTAD können auch andere Lochleitermaterialien eingesetzt werden wie z.B. thiophenhaltige Chinoxaline.

Bei einer weiteren bevorzugten Ausführungsform des erfindungsmäßen Trocken-Verfahrens ist ein Schritt des Bedruckens der im bestimmungsgemäßen Endzustand dem Schichtstapel zugewandten Seite der Folie vorgesehen. Dabei können z.B. Thermodiffusionsfarben und Sublimationsfarben eingesetzt werden.

Wie eingangs genannt liegt der Erfindung auch die Aufgabe zugrunde, eine Perowskit-Solarzelle, insbesondere eine flexible Solarzelle, ein Solarmodul, insbesondere ein flexibles Solarmodul, und ein Verfahren zur deren Herstellung anzugeben, die es ermöglichen, ein in an sich bekannter Weise auf ein geeignetes Trägersubstrat aufgebrachtes Perowskit mit einer Schutzschicht zu überziehen und so zu verkapseln, dass es vor Luft und Wasser geschützt ist, es aber während des Aufbringens der Schutzschicht keiner für das Perowskit schädlichen Wärmebelastung auszusetzen. Diese Aufgabe wird gelöst von einer Perowskit-Solarzelle umfassend:
einen Schichtstapel, der zumindest umfasst: ein Substrat,
eine auf dem Substrat oder vom dem Substrat gebildete erste Elektrodenschicht,
eine auf der ersten Elektrodenschicht gebildete erste photoaktive Schicht in Form einer Perowskit-Schicht mit einem ersten Absorptionsspektrum und eine auf der Perowskit-Schicht gebildete zweite Elektrodenschicht, und
eine den Schichtstapel zu wenigstens einer Seite hin abdeckende, für elektromagnetische Strahlung zumindest des ersten Absorptionsspektrums zumindest partiell transparente Schutzschicht,
wobei die Schutzschicht eine Schicht aus einem elektronenstrahlgehärteten lösemittelfreien Acryllack ist.

Die Eigenschaften des Acryllacks und der solchermaßen ausgebildeten Perowskit-Solarzelle können sämtliche der in den Ansprüchen definierten und oben ausführlich allgemein im Zusammenhang mit Dünnschicht-Solarzellen beschriebenen sein.

Zur Herstellung einer solchen Perowskit-Solarzelle kann ein Verfahren angewandt werden, dass umfasst:
Bereitstellen eines Schichtstapels aus wenigstens einem Substrat, einer auf dem Substrat oder vom dem Substrat gebildeten ersten Elektrodenschicht, einer auf der ersten Elektrodenschicht gebildeten ersten photoaktiven Schicht in Form einer Perowskit-Schicht mit einem ersten Absorptionsspektrum und einer auf der Perowskit-Schicht gebildeten zweiten Elektrodenschicht, und
Aufbringen einer den Schichtstapel zu wenigstens einer Seite hin abdeckenden, für elektromagnetische Strahlung zumindest des ersten Absorptionsspektrums zumindest partiell transparenten Schutzschicht, wobei die Schutzschicht eine Schicht aus einem lösemittelfreien Acryllack ist, und
Elektronenstrahlhärten des Acryllacks.

Zur Herstellung einer solchen Perowskit-Solarzelle kann alternativ ein Verfahren angewandt werden, dass umfasst:
Bereitstellen eines Schichtstapels aus wenigstens einem Substrat, einer auf dem Substrat oder vom dem Substrat gebildeten ersten Elektrodenschicht, einer auf der ersten Elektrodenschicht gebildeten ersten photoaktiven Schicht in Form einer Perowskit-Schicht mit einem ersten Absorptionsspektrum und einer auf der Perowskit-Schicht gebildeten zweiten Elektrodenschicht,
Herstellen einer für elektromagnetische Strahlung zumindest des ersten Absorptionsspektrums zumindest partiell transparenten Folie aus einem lösemittelfreien Acryllack durch Elektronenstrahlhärten des Acryllacks, und
Aufbringen der Folie als Schutzschicht auf den Schichtstapel derart, dass die Folie den Schichtstapel zu wenigstens einer Seite hin abdeckt.

Beide Verfahren können sämtliche der in den Ansprüchen definierten und oben ausführlich allgemein im Zusammenhang mit Dünnschicht-Solarzellen beschriebenen Verfahrensschritte umfassen.

Im Rahmen des Erfindungsgedankens sind zahlreiche Abwandlungen und Weiterbildungen möglich, die sich z.B. auf den verwendeten lösemittelfreien Acryllack und die Ausbildung des Schichtstapels und der einzelnen Schichten in dem Stapel beziehen. So können z.B. weitere Schichten außer den bereits genannten Schichten in, auf oder unter dem Schichtstapel vorgesehen werden, z.B. eine Selbstklebeschicht zum Anbringen der Solarzelle oder die Nutzung des photovoltaischen Effekts begünstigende Schichten.

## Patentansprüche

1. Dünnschicht-Solarzelle umfassend
einen Schichtstapel, der zumindest umfasst: ein Substrat, eine auf dem Substrat oder vom dem Substrat gebildete erste Elektrodenschicht, eine auf der ersten Elektrodenschicht gebildete erste photoaktive Schicht mit einem ersten Absorptionsspektrum und eine auf der ersten photoaktiven Schicht gebildete zweite Elektrodenschicht, und
eine den Schichtstapel zu wenigstens einer Seite hin abdeckende, für elektromagnetische Strahlung zumindest des ersten Absorptionsspektrums zumindest partiell transparente Schutzschicht,
**dadurch gekennzeichnet, dass**
die Schutzschicht eine Schicht aus einem elektronenstrahlgehärteten lösemittelfreien Acryllack ist und
die Schutzschicht auf zumindest einer von ihrer dem Schichtstapel abgewandten Seite und ihrer Schichtstapel zugewandten Seite mit einer funktionalen Struktur versehen ist.

2. Dünnschicht-Solarzelle nach Anspruch 1, **dadurch gekennzeichnet, dass** die funktionale Struktur wenigstens eine ist von einer Bedruckung, einer lichtleitenden Struktur und einer einen Lotus-Effekt erzeugenden Struktur.

3. Dünnschicht-Solarzelle nach Anspruch 1 oder 2, **dadurch gekennzeichnet, dass** die erste photoaktive Schicht eine Perowskit-Schicht ist.

4. Dünnschicht-Solarzelle nach einem der Ansprüche 1 bis 3, **dadurch gekennzeichnet, dass** die Schutzschicht zusammen mit dem Substrat eine vollständige Umhüllung der anderen Schichten des Schichtstapels bildet, wobei Anschlüsse zu den Elektrodenschichten durch die Umhüllung geführt sind.

5. Dünnschicht-Solarzelle nach einem der Ansprüche 1 bis 3, **dadurch gekennzeichnet, dass** die Schutzschicht eine vollständige Umhüllung der anderen Schichten des Schichtstapels bildet, wobei Anschlüsse zu den Elektrodenschichten durch die Umhüllung geführt sind.

6. Dünnschicht-Solarzelle nach einem der Ansprüche 1 bis 5, **dadurch gekennzeichnet, dass** die Solarzelle flexibel ist.

7. Dünnschicht-Solarzelle nach einem der Ansprüche 1 bis 6, **dadurch gekennzeichnet, dass** die Schutzschicht und/oder das Substrat aus einem bei Elektronenbestrahlung radikalisch aushärtenden lösemittelfreien Acryllack, insbesondere einem polymerisierbare Kohlenstoffdoppelbindungen enthaltenden lösemittelfreien Acryllack, vorzugsweise einem hydrophobe Additive enthaltendem lösemittelfreien Acryllack besteht.

8. Dünnschicht-Solarzelle nach einem der Ansprüche 1 bis 7, **dadurch gekennzeichnet, dass** der lösemittelfreie Acryllack etwa 20 bis 70 Gew.-% Oligomere mit einem Molekulargewicht von etwa 500 g/mol und mehr enthält, insbesondere Acrylate, Methacrylate, ungesättigte Polyester, Styrole, Poly-ENE-Thiolsysteme und Isopropene-Styren-Block-Copolymere, aromatische und aliphatische Epoxyacrylate, aromatische und aliphatische Urethanacrylate, Polyester- und Polyetheracrylate und acrylierte Acrylate und acrylierte Öle und/oder etwa 80 bis 30 Gew.-% Monomere mit einem Molekulargewicht von etwa 500 g/mol und weniger enthält, insbesondere Verbindungen mit einer oder mehreren funktionellen Gruppen wie insbesondere Acrylester, Methacrylester, Maleininate, Fumarate, cyclische Vinylamide, Vinylether, Styrol und Allylether.

9. Dünnschicht-Solarzelle nach einem der Ansprüche 1 bis 8, **dadurch gekennzeichnet,**
**dass** der Schichtstapel wenigstens eine zweite photoaktive Schicht mit einem zweiten Absorptionsspektrum, das sich von dem ersten Absorptionsspektrum unterscheidet, umfasst und
**dass** die Schutzschicht auch für elektromagnetische Strahlung des zweiten Absorptionsspektrums zumindest partiell transparent ist.

10. Dünnschicht-Solarzelle umfassend eine Mehrzahl von Dünnschicht-Solarzellen nach einem der Ansprüche 1 bis 9, die in monolithischer Serienschaltung zusammengefügt sind.

11. Verfahren zum Herstellen einer Dünnschicht-Solarzelle umfassend
Bereitstellen eines Schichtstapels aus wenigstens einem Substrat, einer auf dem Substrat oder vom dem Substrat gebildeten ersten Elektrodenschicht, einer auf der ersten Elektrodenschicht gebildeten ersten photoaktiven Schicht mit einem ersten Absorptionsspektrum und einer auf der ersten photoaktiven Schicht gebildeten zweiten Elektrodenschicht, und
Aufbringen einer den Schichtstapel zu wenigstens einer Seite hin abdeckenden, für elektromagnetische Strahlung zumindest des ersten Absorptionsspektrums zumindest partiell transparenten Schutzschicht, wobei die Schutzschicht eine Schicht aus einem lösemittelfreien Acryllack ist,
Erzeugen einer funktionalen Struktur auf der dem Schichtstapel abgewandten Seite der Schutzschicht und
Elektronenstrahlhärten des Acryllacks.

12. Verfahren zum Herstellen einer Dünnschicht-Solarzelle umfassend
Bereitstellen eines Schichtstapels aus wenigstens einem Substrat, einer auf dem Substrat oder vom dem Substrat gebildeten ersten Elektrodenschicht, einer auf der ersten Elektrodenschicht gebildeten ersten photoaktiven Schicht mit einem ersten Absorptionsspektrum und einer auf der ersten photoaktiven Schicht gebildeten zweiten Elektrodenschicht,
Herstellen einer für elektromagnetische Strahlung zumindest des ersten Absorptionsspektrums zumindest partiell transparenten Folie aus einem lösemittelfreien Acryllack unter Erzeugung einer funktionalen Struktur auf zumindest einer Seite der Folie und Aushärten der Folie durch Elektronenstrahlhärten,
Aufbringen der Folie als Schutzschicht auf den Schichtstapel derart, dass die Folie den Schichtstapel zu wenigstens einer Seite hin abdeckt und sich die funktionale Struktur auf zumindest einer von der dem Schichtstapel abgewandten Seite und der dem Schichtstapel zugewandten Seite der Folie befindet.

13. Verfahren nach Anspruch 11 oder 12, **dadurch gekennzeichnet, dass** das Erzeugen der funktionalen Struktur wenigstens einen der folgenden Schritte oder eine beliebige Kombination dieser Schritte umfasst:
- Bedrucken der Schutzschicht vor oder nach deren vollständigem Aushärten,
- Prägen einer lichtleitenden Struktur in die Schutzschicht vor deren vollständigem Aushärten,
- Erzeugen von zumindest Teilen der funktionalen Struktur durch selektive Steuerung eines Elektronenstrahls während des Elektronenstrahlhärten,
- Erzeugen einer einen Lotus-Effekt erzeugenden Oberfläche auf der Schutzschicht durch Prägen einer Mikrostruktur in die Schutzschicht vor deren vollständigem Aushärten und Aufbringen von Nanopartikeln auf die Mikrostruktur vor oder nach dem vollständigen Aushärten der Schutzschicht.

14. Verfahren nach einem der Ansprüche 11 bis 13, **gekennzeichnet durch** Verwenden eines bei Elektronenbestrahlung radikalisch aushärtenden lösemittelfreien Acryllacks, insbesondere eines polymerisierbare Kohlenstoffdoppelbindungen enthaltenden Acryllacks, vorzugsweise eines hydrophobe Additive enthaltenden Acryllacks zur Bildung der Schutzschicht und/oder des Substrats.

15. Verfahren nach einem der Ansprüche 11 bis 14, **gekennzeichnet durch** einen Schritt des Bereitstellens wenigstens einer zweiten photoaktiven Schicht mit einem zweiten Absorptionsspektrum, das sich von dem ersten Absorptionsspektrum unterscheidet, in dem Schichtstapel vor dem Aufbringen der Schutzschicht, wobei die Schutzschicht auch für elektromagnetische Strahlung des zweiten Absorptionsspektrums zumindest partiell transparent ist.
